# EUROPEAN PATENT SPECIFICATION

(11) **EP 0 253 538 B1**
(45) Date of publication and mention of the grant of the patent: **24.03.1993**
(21) Application number: 87305812.7
(22) Date of filing: 01.07.1987
(51) Int. Cl.: H01L 29/72, H01L 21/285

(54) **A VLSI self-aligned bipolar transistor**
Selbstjustierter VLSI bipolarer Transistor
Transistor bipolaire VLSI autoaligné

(30) Priority: 16.07.1986 US 885995
(43) Date of publication of application: 20.01.1988
(73) Proprietor: TEXAS INSTRUMENTS INCORPORATED, Dallas Texas 75265 (US)
(72) Inventor: Brighton, Jeffrey E., Stafford Texas 77477 (US)
(74) Representative: Abbott, David John

(56) References cited:
- EP-A- 0 166 923
- EP-A- 0 168 324
- EP-A- 0 170 250
- FR-A- 2 508 704
- IBM TECHNICAL DISCLOSURE BULLETIN. vol. 26, no. 9, 01 February 1984, NEW YORK US pages 4584 - 4585; S. P. GAUR ET AL: "OPTIMUM LATERAL PNP TRANSISTOR"

## Description

### BACKGROUND OF THE INVENTION

The present Invention relates to a bipolar transistor and method for making same which is self-aligned and capable of being fabricated with small cell size.

The direction of progress in bipolar integrated circuit technology is towards higher levels of integration and greatly reduced transistor cell size. The consequence of reduced cell size is a reduction in the parasitic resistances and capacitances which limit device performance. Since about 1978 various polysilicon self-alignment techniques have been developed in order to achieve such a reduced cell size. While each polysilicon self-aligned device has its own unique characteristics all of them are based on the concept of self-aligning an emitter to an edge of a polysilicon base contacting layer. A common problem with each of these techniques is that a P⁺ doped polysilicon layer must be etched or otherwise removed from a single crystalline silicon region in which an emitter is to be subsequently formed. Any defects induced in the emitter area during the P⁺ etch or during intermediate processing steps prior to emitter formation will degrade the device characteristics. Consequently, known polysilicon self-aligned processes are very complex.

A Cuthbertson et al. in an article entitled "Self-Aligned Transistors with Polysilicon Emitters for Bipolar VLSI" published in IEEE Trans. Electron Devices, v. ED-32, No. 2, pp 242-247, February, 1985, discloses a transistor structure in which the P⁺ inactive base region is self-aligned to a polysilicon emitter and which defines the emitter region early in the fabrication sequence making the emitter less susceptible to surface defects. Furthermore, the single crystal silicon region on which polysilicon is removed is an inactive device area, so dry etch induced damage is less critical. However, in the Cuthbertson et al. transistor, the spacing between the diffused P+ and emitter junctions is defined by thermally oxidizing the edge of the N+ polysilicon emitter which makes junction depth control very difficult. Moreover, the separation of the P+ base and the N+ emitter is not sufficient to inhibit the formation of a P+N+ base-emitter junction which degrades the junction breakdown voltage and the low-current characteristics of the device.

In EP-A-0,168,324 there is described a planar bipolar transistor structure in which a doped polysilicon emitter contact, used to form a self-aligned emitter region, is isolated from a silicide base contact over the base region by residual oxide insulation on the side walls of the polysilicon emitter contact. The collector is a buried region under the base region.

Accordingly, it is a principal object of the invention to provide a bipolar transistor structure and method of fabricating such a structure which allows greater size reduction and improved performance than hitherto known structures. It is a further object of the present invention to provide an improved self-alignment method for forming the emitter and extrinsic base regions. Yet another object of the invention is to provide an improved method of forming a diffused collector contact region.

According to one aspect of the invention there is provided a method of making a self-aligned bipolar transistor on a transistor region of a semiconductor substrate of a first conductivity type, comprising the successive steps of:
forming a buried collector and an overlying epitaxial layer of a second conductivity type on said substrate;
forming an insulating layer over said epitaxial layer having a base region opening;
implanting a base region in said epitaxial layer with an impurity of a first conductivity type using said insulating layer as a mask;
depositing, implanting with an impurity of a second conductivity type and patterning an emitter contact layer of polysilicon such that a portion thereof contacts said epitaxial layer in an emitter region nested within said base region, after having formed a sidewall insulating plug on the edge of said insulating layer defining said base region in order to space a first edge of, the emitter polysilicon contact layer from an edge of said insulating layer;
forming a second sidewall insulating plug on a second edge of the emitter polysilicon in the base region;
depositing a base contact layer of polysilicon of the first conductivity type on a portion of the base region adjacent said second sidewall insulating plug;
forming a collector contact region in said transistor region; and
annealing said transistor region to activate impurity regions and drive impurity from said emitter and base polysilicon contact layers into said epitaxial layer below to form diffused emitter and base regions.

A polysilicon base contact layer may be formed over part of the intrinsic base region and implanted with an impurity of the second conductivity type prior to the annealing step the extrinsic base region being formed by diffusion of the impurity from the polysilicon base contact layer.

Silicide may be formed over the base and emitter polysilicon layers as well as the collector contact region in order to enhance ohmic contact and to reduce resistance along the polysilicon to a corresponding contact.

Advantageously, an isolation means is provided in the form of a deep narrow trench extending down through the epitaxial layer into the substrate and enclosing the transistor region.

According to a second aspect of the invention there is provided a bipolar transistor comprising
a semiconductor substrate of a first conductivity type;
a buried collector on the substrate and an overlying epitaxial layer, both of a second conductivity type, an insulating layer over the epitaxial layer having a base region opening;
a base region of the first conductivity type, formed within the epitaxial layer;
a sidewall insulating plug formed on the sidewall of the insulating layer around the base region opening, first and second portions of the sidewall insulating plug being on opposite sides of the base opening from each other;
a doped emitter polysilicon contact layer on part of the surface of the base region that lies within the base region opening up to and overlying the first portion of the sidewall insulating plug and part of the insulating layer;
a doped polysilicon base contact layer on part of the surface of the base region;
an emitter region of the second conductivity type nested within the base region beneath the emitter polysilicon contact layer where it contacts the base region, an extrinsic base region of the first conductivity type beneath the polysilicon base contact layer where it contacts the surface of the base region, and a collector contact region extending through said epitaxial layer to said buried collector,
characterised in that
said intrinsic and said extrinsic base regions are formed within said base region opening;
an insulating layer and spacer plug overlies the edge of the emitter polysilicon contact layer on the base region and overlying part of the base region within the base opening;
and that said polysilicon base contact layer is provided upto and overlying part of the insulating layer and spacer plug.

The novel features believed characteristic of the invention are set form in the appended claims. The invention itself, however, as well as other features and advantages thereof, will be best understood by reference to the detailed description which follows, read in conjunction with the accompanying drawings, wherein:

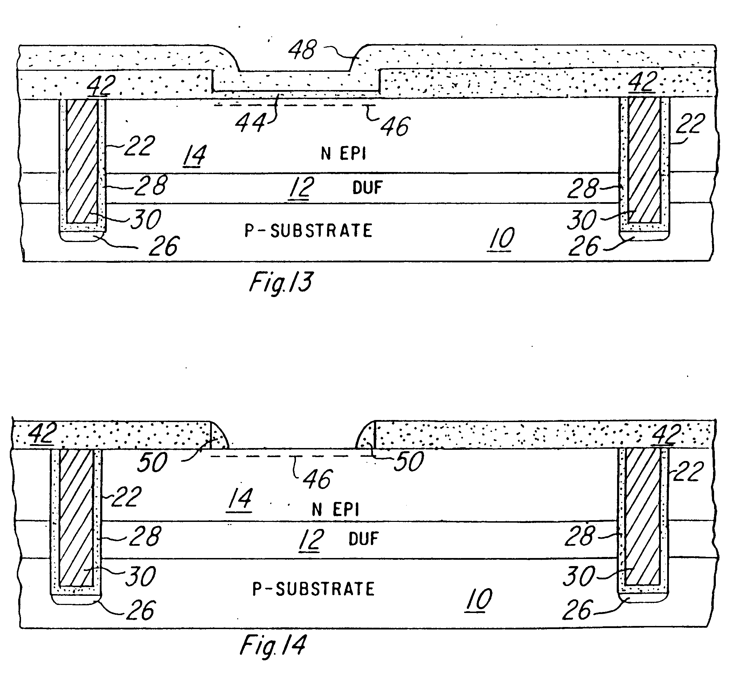

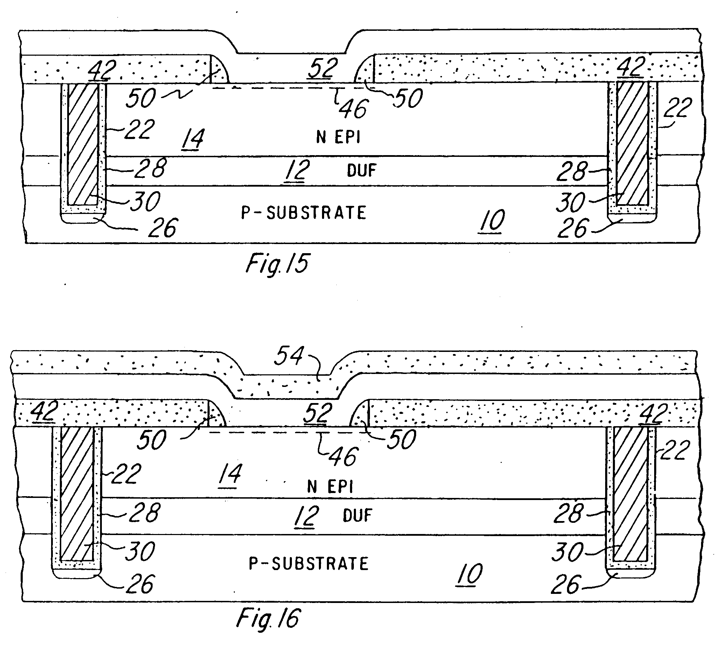

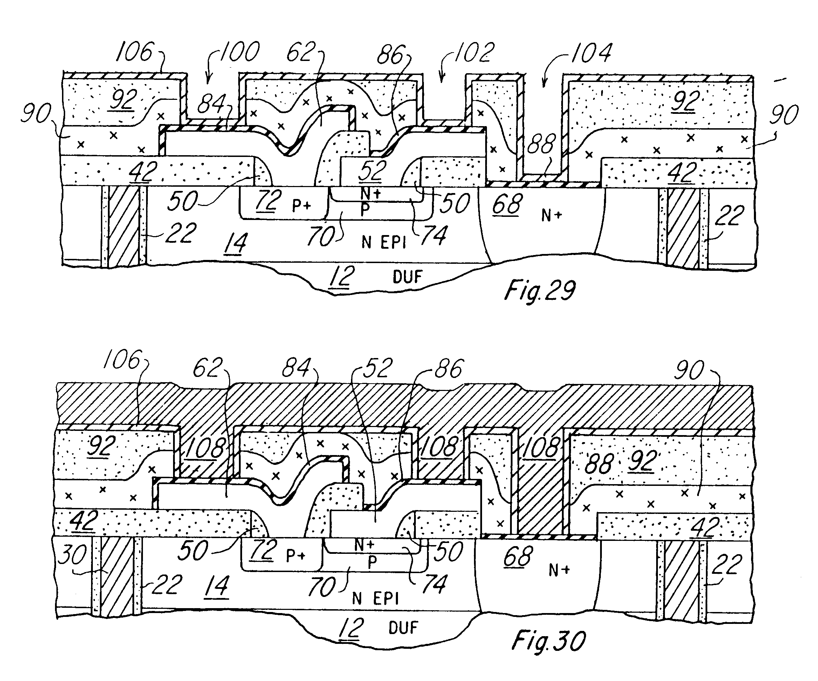

Figs. 1 to 32 are greatly enlarged cross sectional views in elevation of a small portion of a semiconductor chip showing various stages in the fabrication of the bipolar transistor cell made in accordance with a preferred embodiment of the invention; and
Fig. 33 is a greatly enlarged top view of a small portion of a semiconductor chip showing the physical layout of one bipolar transistor made in accordance with the present invention.

### DETAILED DESCRIPTION OF A PREFERRED EMBODIMENT

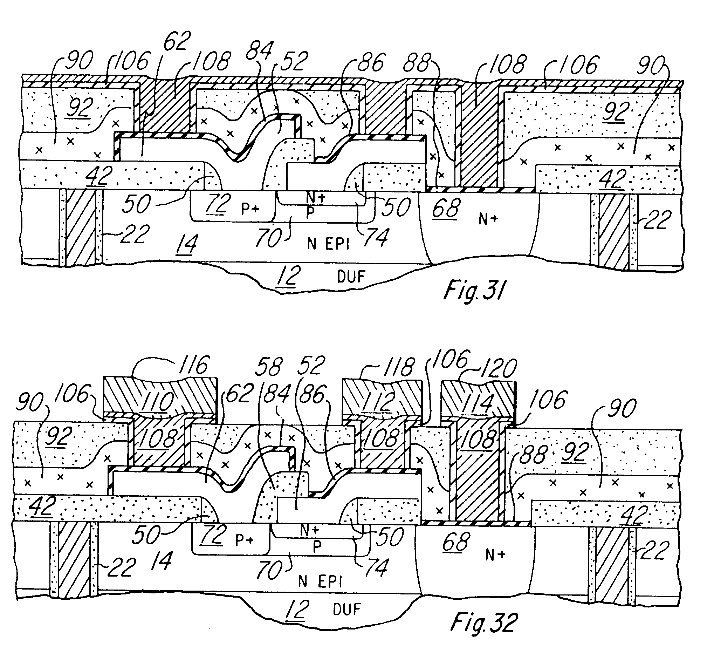

With reference to Figure 32 there is shown in cross section a bipolar transistor being one of many formed on each of a number of silicon bars. The bars are formed from a silicon slice. In accordance with a preferred embodiment of the present invention each transistor consists of a monocrystalline P-type silicon substrate 10 having an N-type antimony implanted DUF collector region 12 extending a thickness of about 3 to 3.5 µm (microns) into the slice. An N-type epitaxial layer 14 is deposited over the DUF region 12 to a thickness of 1.0 to 1.4 µm (microns).Polysilicon filled trenches 22 divide up the substrate 10 and epitaxial layer 14 into a number of regions in which bipolar transistors are formed. Each transistor consists of a heavily doped shallow intrinsic base region 70 extending down only 200 to 400 nm (2,000 to 4,000 Å) brought to a surface contact by a heavily doped P⁺ region 72. The P⁺ region 72 is contacted by a layer of P⁺ polysilicon 62 with a thin film of platinum silicide 84 formed on top of the polysilicon 62 to enhance ohmic contact and reduce base resistance.
A shallow emitter 74 of about 50 to 200 nm (500 to 2,000 Å) depth is formed in the base region 70 by diffusion from a phosphorous (or arsenic) doped polysilicon layer 52. A deep collector contact 68 is formed in the epitaxial region 14 to make contact with the DUF region 12 which acts as a buried collector. Again ohmic contact enhancement is provided by platinum silicide layers 86 and 88 to emitter polysilicon layer 52 and collector contact 68, respectively. Metal contacts 116, 118 and 120 consist of a a thin sticking layers of titanium-tungsten 106 followed by tungsten plugs 108 and aluminum leads 110, 112 and 114. Alternatively, molybdenum could be used in place of the titanium tungsten.

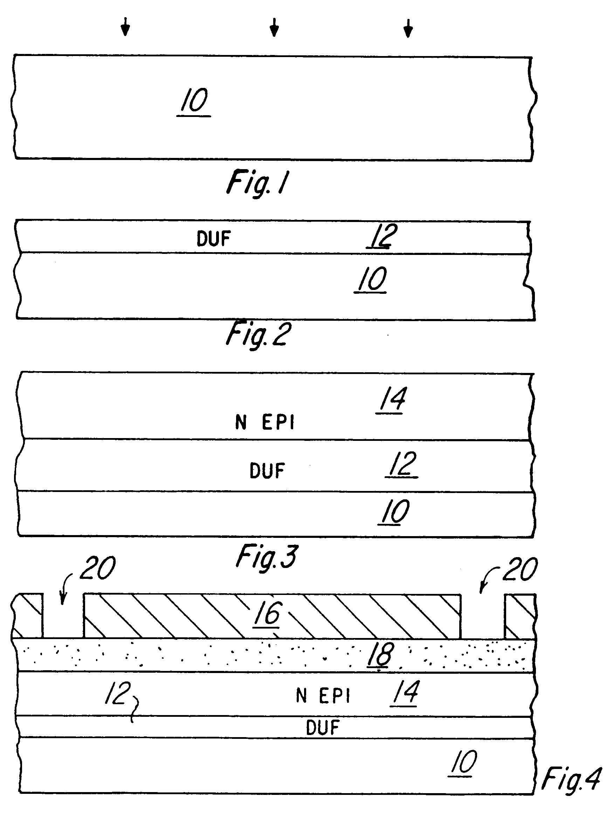

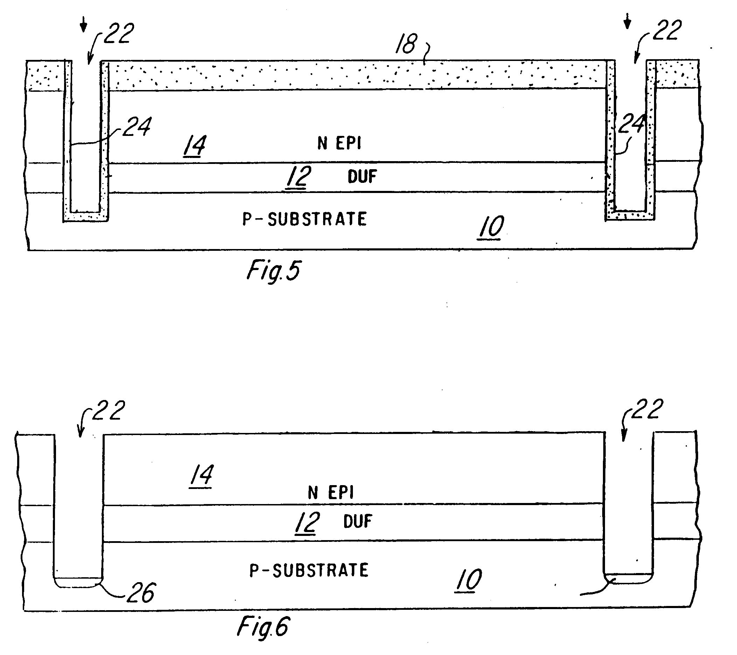

Referring to Figures 1, 2 and 3, a P-type substrate 10 is subjected to a blanket implant of antimony to a post anneal depth of 3 to 3.5 µm (microns)and a final sheet resistance of 15 - 20 ohms per square. Since antimony diffuses much more slowly in silicon than do other types of donor impurities such as phosphorus or arsenic, up-diffusion into the overlying epitaxial layer will be significantly less. Next as seen in Figure 3, an N-type epitaxial layer 14 is deposited over the antimony implanted DUF region 12 at reduced pressure to a thickness of 1.0 to 1.4 µm (microns) with a resistivity of 0.3 to 1.0 ohm-cm. This thickness of epitaxial layer 14 is about 20% less than the thicknesses of epitaxial layers used in conventional technologies and requires shallow emitter and base regions.

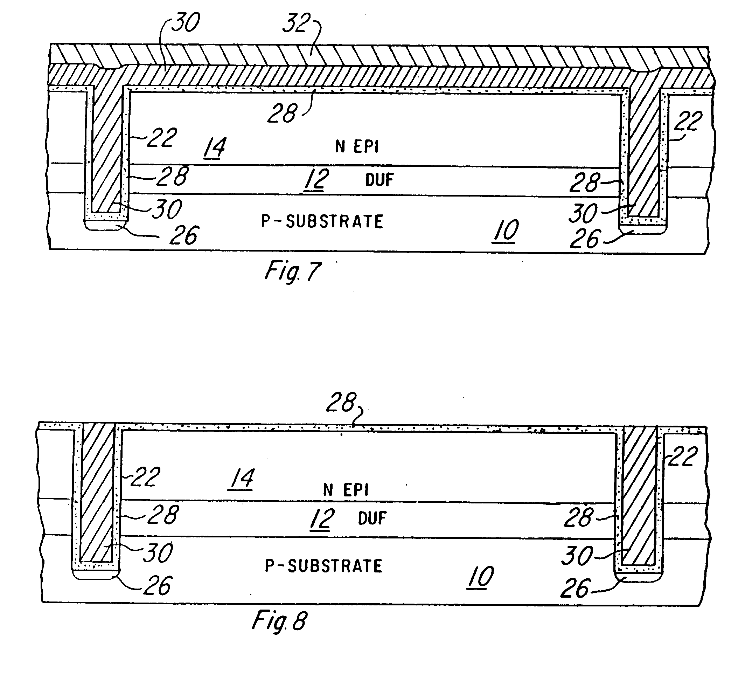

A layer of silicon dioxide 18 is then deposited to a thickness of about 1.0 to 1.5 µm (microns).A layer of photoresist 16 is then deposited over the silicon dioxide 18, exposed to ultra violet light through a mask (not shown), and the exposed portions removed in order to open a number of spaced apart trench regions 20 as shown in Figure 4. The trench regions 20 are then etched to form deep trenches 22 extending below the DUF region having a width of 1.5 to 2.0 µm (microns).Next a sidewall oxide 24 is grown over the walls of the trenches 22 by placing the cell in an atmosphere of steam at a temperature of approximately 1,000 ^{o}C for about 15 minutes. A channel stop boron implant is then directed into the trenches 22 at an energy of 40 to 60 keV and a concentration of about 1 x 10¹⁴ atoms per square centimeter to form a P⁺ channel stop region 26 below each trench 22 in order to prevent an inversion layer from forming around the trench oxide sidewall 20. An etch removes the layer of silicon dioxide 24 on the sidewalls of the trench 22 and the oxide 18 on the top of the epitaxial layer 14 as shown in Figure 6. A second sidewall oxide is grown over the trench walls and face of the epitaxial layer 14.

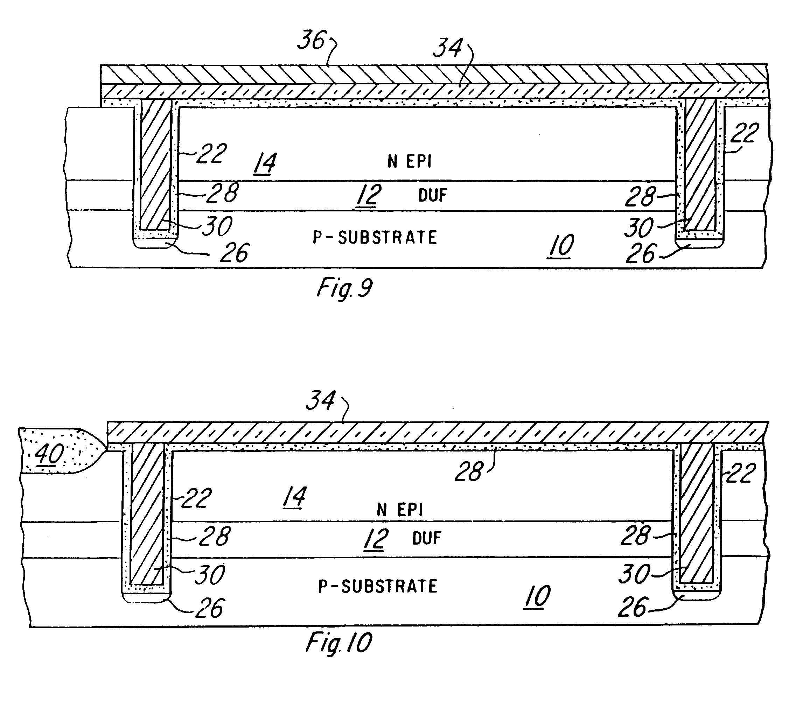

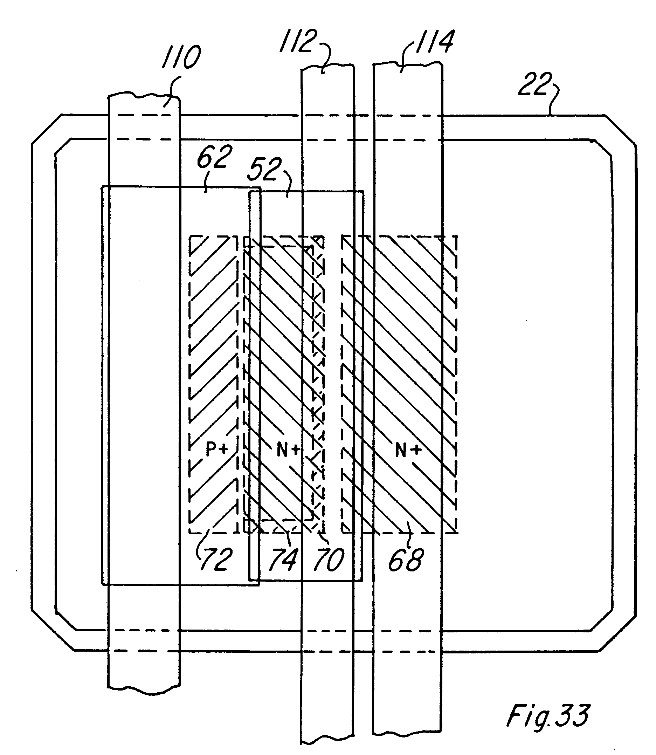

Next the trenches 18 are filled with a polysilicon deposit 30 as seen in Figure 7 and onto the latter layer is deposited a layer of photoresist 32 which is flat. A dry etch chemistry is selected so that the photoresist 32 and underlying polysilicon 30 etch as substantially the same rate. Etching of the photoresist 32 and polysilicon 30 down to oxide layer 28, produces a flat oxide surface 28 as shown in Figure 8. Referring to Figures 32 and 33 the design of the trenches is substantially rectangular with the corners angled off in order to preserve substantially the same channel width around the corners and avoid voids when filling with polysilicon. By using such trenches as isolation regions the oxide encroachment into the active device area present in devices using ordinary oxide isolation is avoided and the packing density can be increased significantly. In oxide isolation the current design rule requires a separation of 8-10 µm (microns) between transistors whereas with a polysilicon filled trench the 1.5 to 2.0 µm(micron)width of the trench is the limit in separation.

Referring to Figure 9, a layer of silicon nitride 34 is formed over oxide surface 28 by low pressure chemical vapor deposition. A layer of photoresist 36 is deposited over the nitride 34 and then patterned and the exposed isolation region 38 etched to remove the nitride 30 and oxide 28 as seen in Figure 10. The photoresist 36 is stripped and the entire slice is then exposed to an oxidizing high pressure atmosphere at about 900 ^{o}C. for about 2 hours. During oxidation silicon is consumed so that a relatively thick oxidation isolation region 40 as seen in Figure 10 is formed.

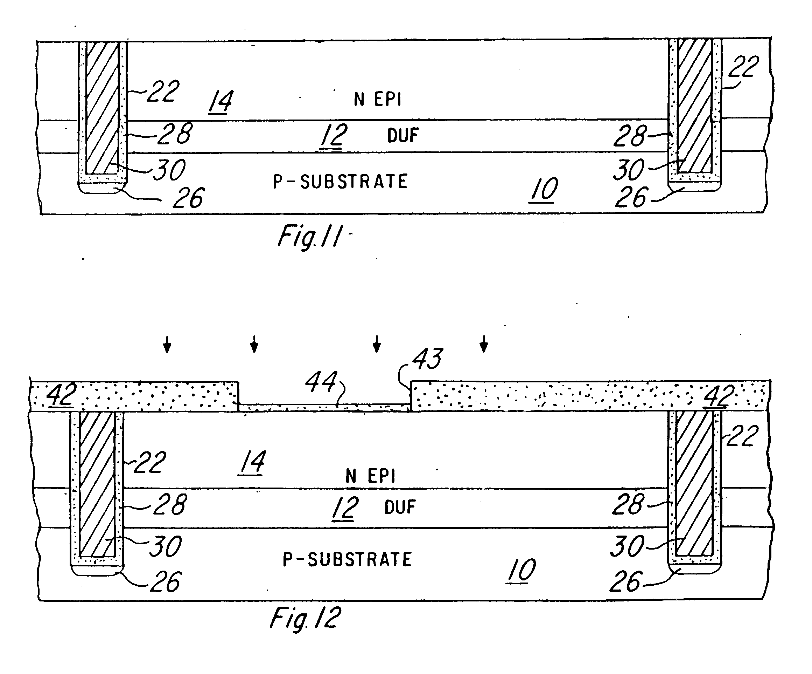

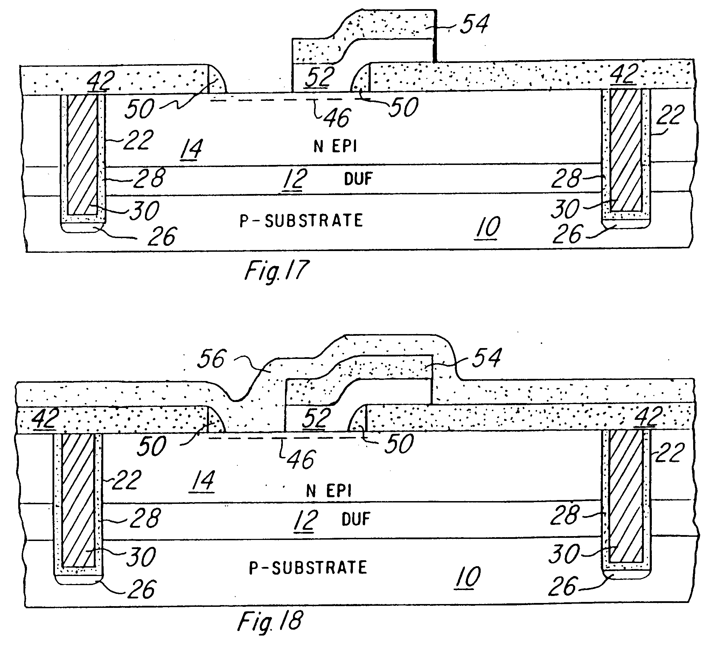

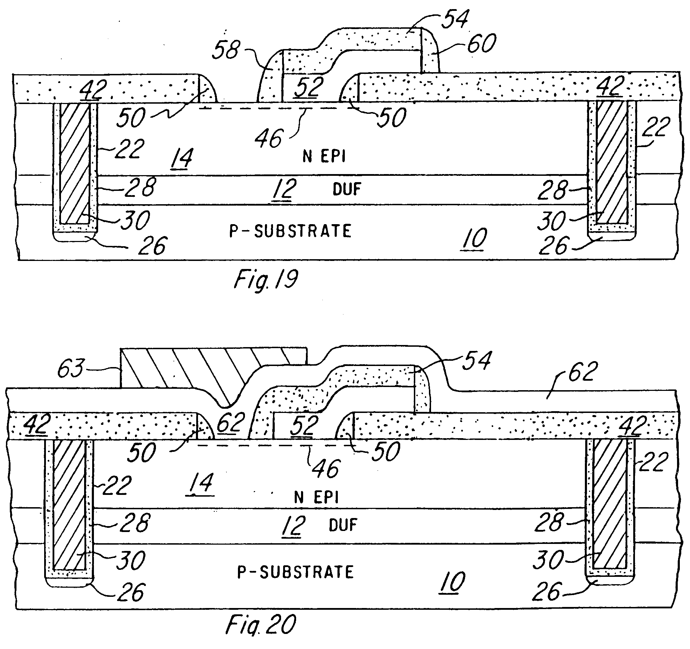

Next, as shown in Figure 11 the remaining nitride 34 is etched off as is the oxide 28 over the epitaxial region 14. A layer of oxide is grown over epitaxial layer 14 to a thickness of about 300 to 500 nm (3,000 to 5,000Å) or deposited by known means and a base region 43 patterned and etched in the oxide 42 as shown in Figure 12. A thin oxide 44 in the range of 50 to 120 nm (500 to 1,200 Å) is grown over the exposed epitaxial surface in opening 43 and then the epitaxial surface implanted with boron 46 through the oxide 44 to a shallow depth. Following the boron implant another thick oxide layer 48 is deposited and a reactive ion etch done to leave sidewall segment 50 around opening 43. A polysilicon layer 52 is then deposited and doped with either phosphorous or arsenic followed by the deposition of another oxide layer 54. Segment 50 ensures a smooth gradual transition over the sidewalls of opening 43 and ensures that the emitter 74 will be nested within the intrinsic base region 70. Both the polysilicon 52 and the oxide 54 are patterned and etched opening an extrinsic base part of the epitaxial surface within opening 43 and leaving an emitter polysilicon layer 52 and an overlying oxide layer 54 as shown in Figure 17. Another layer of oxide 56 is deposited over the transistor region, and subjected to reactive ion etching leaving sidewall plugs 58 and 60 as shown in Figure 19.

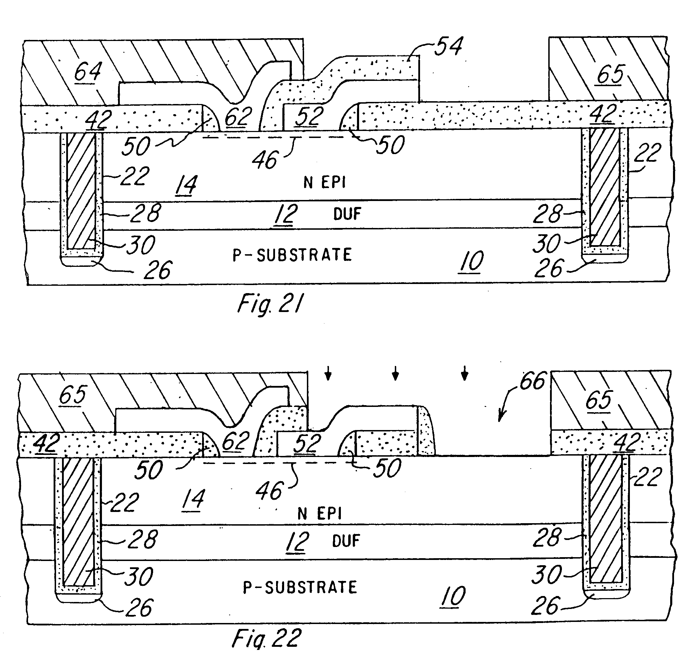

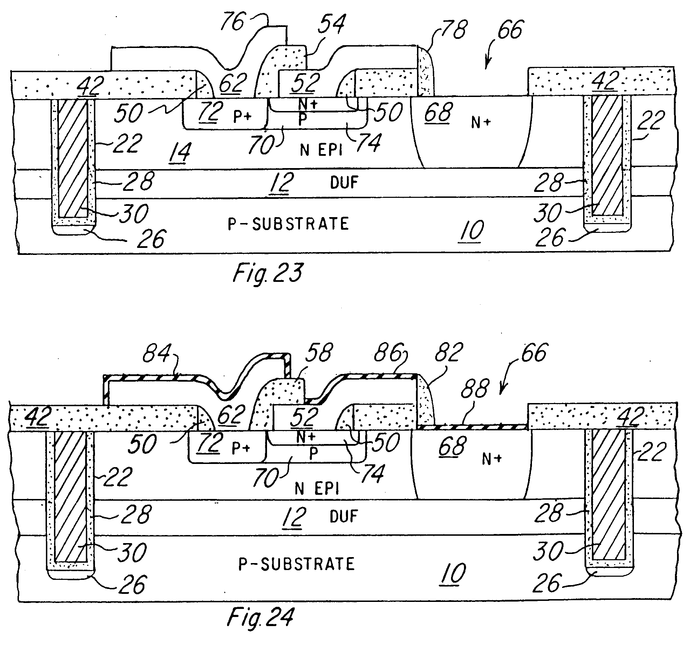

Following formation of sidewall plugs or segments 50 and 58, a second layer of polysilicon 62 is deposited and ion implanted with boron followed by a deposit of photoresist 63. Photoresist 63 is patterned as shown in Figure 20 and the polysilicon layer 62 etched to leave a base polysilicon layer 62 as shown in Figure 21. Photoresist layer 65 is deposited and patterned to leave an opening over a portion of oxide layers 54 and 42 and the oxide etched to expose both emitter polysilicon layer 52 and collector contact region 66 as shown in Figure 22. A deep collector contact implant of phosphorous at an energy of 100 to 120 keV is effected with an implant dose in the range of 1 x 10¹⁶ to 3 x 10¹⁶ atoms per square centimeter using the same photoresist pattern. Alternatively the implant could be arsenic rather than phosphorous. The photoresist 65 is then stripped and the device given a short anneal to drive the dopant from the emitter and extrinsic base polysilicon layers 52 and 62, respectively, to activate and drive the phosphorous in the collector contact region, to activate and diffuse the intrinsic base boron implant 46, and to anneal implant damage. The resulting structure is shown in Figure 23. The diffused P⁺ region 72 extends approximately 200 to 400 nm (2,000 to 4,000 Å) below the silicon surface and has a sheet resistance of 80 to 100 ohms per square. The P-type region 70 resulting from the intrinsic implant extends down about the same distance as the extrinsic base region 72 and has a sheet resistance in the range of approximately 600 to 800 ohms per square. This high level of base doping reduces base resistance and hence decreases gate delay and switching time. All of the above junction depths and sheet resistance values are final process values.

Referring to Figure 24, platinum is sputtered over the surface of the transistor region and sintered so that in regions where platinum is in contact with silicon, platinum silicide is formed leaving silicide layers 84, 86, and 88. These silicide, layers are formed on the collector contact region 68 in alignment with polysilicon layer 52 and on the latter in near alignment with base polysilicon layer 62. They serve to enhance ohmic contact of subsequently deposited metal layers as well as lower resistance along the layers of polysilicon.

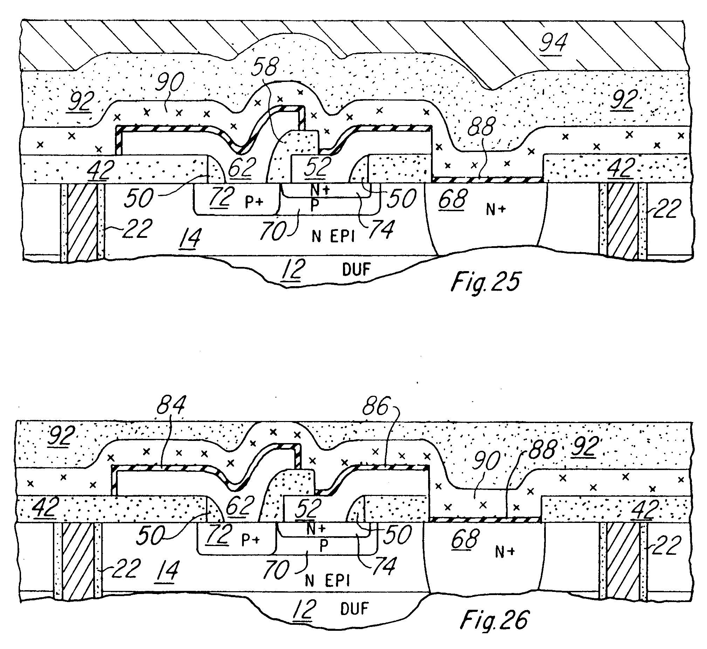

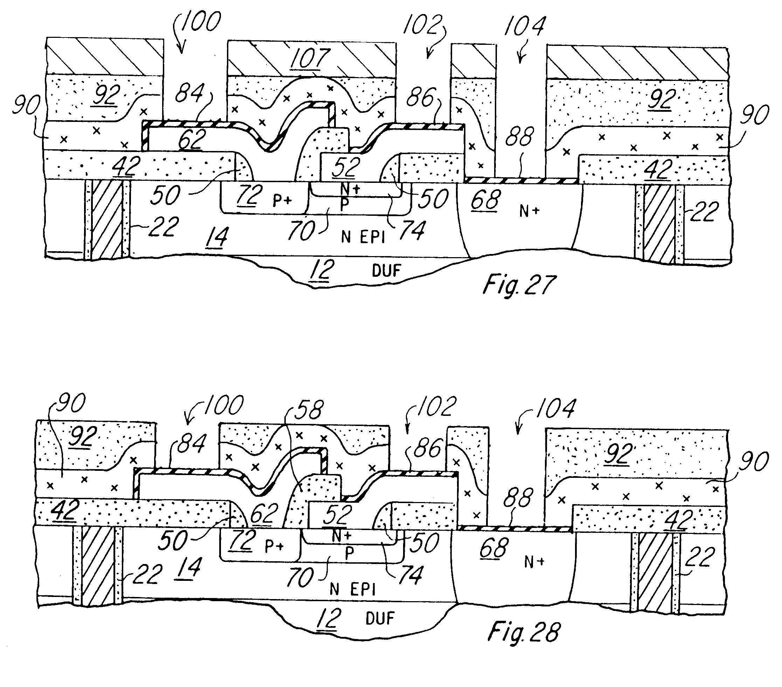

A conformal coating of phosphosilicate glass 90 is deposited over the structure of Figure 24 to passivate the surface, followed by a thick layer of oxide 92 and a spun on layer of photoresist 94. Etching back the photoresist 94 and oxide 92 using a dry etch chemistry which produces substantially the same etch rate in the photoresist 94 as in the oxide 92 leaves a flat topped oxide 92 as shown in Figure 26. Yet another photoresist layer 107 is deposited and patterned to open contact areas on the base polysilicon 62, the emitter polysilicon 52, and the collector contact 68. The underlying oxide 92 and PSG (phospho silicate glass) 90 is etched opening the latter-mentioned contact holes. Because the etch is highly selective and etches the silicide much more slowly than the oxide contact opening 104 which is deeper than contact openings 100 and 102 can be etched at the same time as the latter two openings. The photoresist is stripped leaving the structure of Figure 28 and then a sticking layer of titanium-tungsten is sputtered onto the slice leaving an almost a conformal coating of titanium-tungsten 106. A thick layer of tungsten 108 is then chemically vapor deposited over the sticking layer 106 filling in openings 100, 102 and 104. Another photoresist layer (not shown) is deposited over the tungston 108 in a spin on process and then etched back with an etch chemistry having a 1:1 selectivity of tungsten to photoresist leaving only a thin relatively flat layer of tungsten 108 over the underlying oxide 90 as shown in Figure 31. An aluminum layer is deposited over the remaining tungsten layer 108 and patterned and etched down to oxide 90 leaving leads 110, 112 and 114 as shown in Figure 32.

A top view of the transistor region of a slice shown in Figure 33 indicates the three leads 110, 112 and 114 running along the surface of the slice together with underlying base polysilicon 62 and emitter polysilicon 52. Also shown are diffused extrinsic base 72, emitter 74, intrinsic base 70 and collector contact 68. The trench structure as seen is angled at 45^{o} to each side both on the outside and inside walls so as to maintain a constant width at the corners and avoid voiding in the polysilicon used to fill the trench.

It will be appreciated that both the extrinsic base and the collector contact regions are self-aligned with respect to opposed side walls of emitter polysilicon layer 52. Moreover, the emitter is nested within the intrinsic base via the self-aligned formation of sidewall plug 50, and the extrinsic base is spaced from the emitter by sidewall segment 58 thus allowing extremely close spacing without the formation of an undesirable P⁺N⁺ junction. The spacing between the collector contact region 68 and the emitter polysilicon layer 52 can also be made small due to the self-alignment method of defining the collector contact region.

The use of shallow junctions allows a thin epitaxial layer be used without increasing collector base capacitance significantly. A thin epitaxial deposit which in this case is about 1.0 to 1.4 µm(microns) reduces the collector resistance as well as the charge storage under the active base. The use of a deep collector implant followed by a short anneal provides a method of reducing the collector resistance to a greater extent than is possible by the conventional means of phosphorus-oxychloride diffusion as well as providing better control over diffusion profiles.

The use of antimony which diffuses much more slowly in silicon than do other impurities such as phosphorus limits the amount of up-diffusion of the buried collector or DUF region 14 and therefore allows a thinner epitaxial layer 12. The use of a deep narrow trench allows a substantially greater packing density by nearly an order of magnitude than would be possible with conventional oxide isolation.

Utilization of a high efficiency polysilicon diffused emitter, makes it possible to increase the active base doping. A heavily doped base, in turn means a lower base resistance and hence a lower gate delay or switching time. Moreover, using only a shallow base implant of boron and relying on diffusion of dopant from the polysilicon layers 62 and 52 into the extrinsic base 72 and emitter 74 avoids damage that would otherwise result if implants were made instead.

## Claims

1. A method of making a self-aligned bipolar transistor on a transistor region of a semiconductor substrate (10) of a first conductivity type, comprising the successive steps of:
forming a buried collector (12) and an overlying epitaxial layer (14) of a second conductivity type on said substrate;
forming an insulating layer (42) over said epitaxial layer (14) having a base region opening (43);
implanting a base region (70) in said epitaxial layer (14) with an impurity of a first conductivity type using said insulating layer (42) as a mask;
depositing, implanting with an impurity of a second conductivity type and patterning an emitter contact layer (52) of polysilicon such that a portion thereof contacts said epitaxial layer (14) in an emitter region (74) nested within said base region (70), after having formed a sidewall insulating plug (50) on the edge of said insulating layer (42) defining said base region in order to space a first edge of the emitter polysilicon contact layer (52) from an edge of said insulating layer (42);
forming a second sidewall insulating plug (58) on a second edge of the emitter polysilicon in the base region;
depositing a base contact layer (62) of polysilicon of the first conductivity type on a portion of the base region adjacent said second sidewall insulating plug (58);
forming a collector contact region (68) in said transistor region; and
annealing said transistor region to activate impurity regions and drive impurity from said emitter and base polysilicon contact layers (52,62) into said epitaxial layer below to form diffused emitter and base regions.

2. A method according to claim 1, including forming silicide (84,86,88) over said polysilicon base and emitter contact layers (62,52).

3. A method according to claim 1 or 2, wherein said collector contact region (68) is aligned to an edge of said polysilicon emitter contact layer (52) remote from said intrinsic base region (70).

4. A method according to any one of claims 1 to 3, wherein said first conductivity type is P-type and said second conductivity type is N-type.

5. A bipolar transistor comprising
a semiconductor substrate (10) of a first conductivity type;
a buried collector (12) on the substrate and an overlying epitaxial layer (14), both of a second conductivity type, an insulating layer (42) over the epitaxial layer having a base region opening (43);
a base region (70) of the first conductivity type, formed within the epitaxial layer (14);
a sidewall insulating plug (50) formed on the sidewall of the insulating layer (42) around the base region opening (43), first and second portions of the sidewall insulating plug being on opposite sides of the base opening (43) from each other;
a doped emitter polysilicon contact layer (52) on part of the surface of the base region (70) that lies within the base region opening (43) up to and overlying the first portion of the sidewall insulating plug (50) and part of the insulating layer (42);
a doped polysilicon base contact layer (62) on part of the surface of the base region (70);
an emitter region (74) of the second conductivity type nested within the base region (70) beneath the emitter polysilicon contact layer (52) where it contacts the base region (70), an extrinsic base region (72) of the first conductivity type beneath the polysilicon base contact layer (62) where it contacts the surface of the base region (70), and a collector contact region (68) extending through said epitaxial layer (14) to said buried collector (12),
characterised in that
said intrinsic and said extrinsic base regions are formed within said base region opening (43);
an insulating layer and spacer plug (58) overlies the edge of the emitter polysilicon contact layer (52) on the base region and overlying part of the base region within the base opening (43);
and that said polysilicon base contact layer (62) is provided upto and overlying part of the insulating layer and spacer plug (58).

6. A bipolar transistor according to claim 5, including a silicide layer (84,86,88) formed over said emitter and base polysilicon contact layers (52,62) and said collector contact region (68).

7. A transistor according to claim 5 or claim 6 wherein said collector contact region (68) is aligned with an edge of said polysilicon emitter contact layer (52) remote from said intrinsic base region (70).

8. A transistor according to any one of claims 5, 6 and 7, wherein said first conductivity type is P-type and said second conductivity type is N-type.

## Patentansprüche

1. Verfahren zur Herstellung eines selbst-ausgerichteten bipolaren Transistors auf einem Transistorgebiet eines Halbleitersubstrats (10) eines ersten Leitungstyps, das die aufeinanderfolgenden Schritte enthält:
auf dem Substrat wird ein vergrabener Kollektor (12) und eine darüberliegende Epitaxialschicht (14) eines zweiten Leitungstyps gebildet;
über der Epitaxialschicht (14) wird eine Isolierschicht (42) gebildet, die eine Basiszonenöffnung (43) hat;
in der Epitaxialschicht (14) wird eine Basiszone (70) mit einem Störstoff eines ersten Leitungstyps implantiert, wobei die Isolierschicht (42) als Maske verwendet wird;
durch Implantierung mit einem Störstoff eines zweiten Leitungstyps und Formgebung wird eine Emitterkontaktschicht (52) aus Polysilicium so aufgebracht, daß ein Abschnitt davon die Epitaxialschicht (14) in einer Emitterzone (74) kontaktiert, die in die Basiszone (70) eingebettet ist, nachdem am Rand der Isolierschicht (42) ein Seitenwand-Isolierabschluß (50) gebildet worden ist, der die Basiszone definiert, um einen ersten Rand der Emitter-Polysiliciumkontaktschicht (52) von einem Rand der Isolierschicht (42) im Abstand zu halten;
an einem zweiten Rand des Emitter-Polysiliciums wird ein zweiter Seitenwand-Isolierabschluß (58) in der Basiszone gebildet;
auf einen Abschnitt der Basiszone, der an den zweiten Seitenwand-Isolierabschluß (58) angrenzt, wird eine Basiskontaktschicht (62) aus Polysilicium des ersten Leitungstyps aufgebracht;
in dem Transistorbereich wird eine Kollektorkontaktzone (68) gebildet; und
der Transistorbereich wird getempert, um Störstoffzonen zu aktivieren und Störstoff aus den Emitter- und Basis-Polysiliciumkontaktschichten (52, 62) in die darunterliegende Epitaxialschicht zu treiben, damit diffundierte Emitter- und Basiszonen gebildet werden.

2. Verfahren nach Anspruch 1, bei welchem eine Siliciumverbindung (84, 86, 88) über den Basis- und Emitter-Polysiliciumkontaktschichten (62, 52) gebildet wird.

3. Verfahren nach Anspruch 1 oder 2, bei welchem die Kollektorkontaktzone (68) auf einen Rand der Emitter-Polysiliciumkontaktschicht (52) ausgerichtet wird, der von der inneren Basiszone (70) entfernt ist.

4. Verfahren nach einem der Ansprüche 1 bis 3, dadurch gekennzeichnet, daß der erste Leitungstyp ein p-Typ und der zweite Leitungstyp ein n-Typ ist.

5. Bipolarer Transistor, enthaltend:
ein Halbleitersubstrat (10) eines ersten Leitungstyps;
einen vergrabenen Kollektor (12) auf dem Substrat und eine darüberliegende Epitaxialschicht (14), die beide von einem zweiten Leitungstyp sind, sowie einer Isolierschicht (42) über der Epitaxialschicht, die eine Basiszonenöffnung (43) hat;
eine Basiszone (70) des ersten Leitungstyps, die in der Epitaxialschicht (14) gebildet ist;
einen Seitenwand-Isolierabschluß (50), der an der Seitenwand der Isolierschicht (42) um die Basiszonenöffnung (43) gebildet ist, wobei erste und zweite Abschnitte des Seitenwand-Isolierabschlusses an einander entgegengesetzten Seiten der Basisöffnung (43) sind;
eine dotierte Emitter-Polysiliciumkontaktschicht (52) auf einem Teil der Oberfläche der Basiszone (70), der in der Basiszonenöffnung (43) bis zu und über dem ersten Abschnitt des Seitenwand-Isolierabschlusses (50) und einem Teil der Isolierschicht (42) liegt;
eine dotierte Basis-Polysiliciumkontaktschicht (62) auf einem Teil der Oberfläche der Basiszone (70);
eine Emitterzone (74) des zweiten Leitungstyps, die in die Basiszone (70) unter der Emitter-Polysiliciumkontaktschicht (52) eingebettet ist, wo sie die Basiszone (70) kontaktiert, sowie eine äußere Basiszone (72) des ersten Leitungstyps unter der Basis-Polysiliciumkontaktschicht (62), wo sie die Oberfläche der Basiszone (70) kontaktiert, und eine Kollektorkontaktzone (68), die sich durch die Epitaxialschicht (14) zu dem vergrabenen Kollektor (12) erstreckt,
dadurch gekennzeichnet, daß die innere und die äußere Basiszone in der Basiszonenöffnung (43) gebildet sind;
ein Isolierschicht- und Abstandsabschluß (58) über dem Rand der Emitter-Polysiliciumkontaktschicht (52) auf der Basiszone und über einem Teil der Basiszone in der Basisöffnung (43) liegt;
und daß die Basis-Polysiliciumkontaktschicht (62) bis zu und über einem Teil des Isolierschicht- und Abstandabschlusses (58) liegend vorgesehen ist.

6. Bipolarer Transistor nach Anspruch 5, mit einer Schicht aus einer Siliciumverbindung (84, 86, 88), die über den Emitter- und Basis-Polysiliciumkontaktschichten (52, 62) und der Kollektorkontaktzone (68) gebildet ist.

7. Transistor nach Anspruch 5 oder 6, bei welchem die Kollektorzone (68) auf einen Rand der Emitter-Polysiliciumkontaktschicht (52) ausgerichtet ist, der von der inneren Basiszone (70) entfernt ist.

8. Transistor nach einem der Ansprüche 5, 6 und 7, bei welchem der erste Leitungstyp ein p-Typ und der zweite Leitungstyp ein n-Typ ist.

## Revendications

1. Procédé de fabrication d'un transistor bipolaire à grille auto-alignée sur une zone de transistor d'un substrat semiconducteur (10) d'un premier type de conductivité, comprenant les étapes successives suivantes:
- former un collecteur enterré (12) et une couche épitaxiale de recouvrement (14) d'un second type de conductivité sur ledit substrat ;
- former une couche isolante (42) sur ladite couche épitaxiale (14) avec une ouverture de zone de base (43) ;
- implanter une zone de base (70) dans ladite couche épitaxiale (14) avec une impureté d'un premier type de conductivité en utilisant ladite couche isolante (42) en tant que masque ;
- déposer, implanter avec une impureté d'un second type de conductivité et former des motifs d'une couche de contact d'émetteur (52) de polysilicium telle qu'une partie de cette dernière soit en contact avec ladite couche épitaxiale dans une zone d'émetteur (74) emboîtée dans ladite zone de base (70) après avoir formé une barrette isolante (50) latérale sur le bord de ladite couche isolante (42) en définissant ladite zone de base afin d'espacer un premier bord de la couche de contact d'émetteur (52) en polysilicium d'un bord de ladite couche isolante (42) ;
- former une seconde barrette isolante (58) latérale (58) sur un second bord du polysilicium de l'émetteur dans la zone de base ;
- déposer une couche de contact de base (62) en polysilicium du premier type de conductivité sur une partie de la zone de base adjacente à ladite seconde barrette isolante (58) latérale ;
- former une zone de contact de collecteur (68) dans ladite zone de transistor ; et
- recuire ladite zone de transistor pour activer les zones à impureté et pour entraîner l'impureté à partir desdites couches de contact d'émetteur et de base en polysilicium (52,62) dans ladite couche épitaxiale, en dessous pour former des zones d'émetteur et de base diffusées.

2. Procédé selon la revendication 1, comprenant la formation de siliciure (84,86,88) sur lesdites couches de contact de base et d'émetteur (52,62) en polysilicium.

3. Procédé selon la revendication 1 ou 2, dans lequel ladite zone de contact de collecteur (68) est alignée sur un bord de ladite couche de contact en polysilicium d'émetteur (52) à distance de ladite zone de base intrinsèque (70).

4. Procédé selon l'une quelconque des revendications 1 à 3, dans lequel ledit premier type de conductivité est le type P et le deuxième type de conductivité est le type N.

5. Transistor bipolaire comprenant :
- un substrat semiconducteur (10) d'un premier type de conductivité ;
- un collecteur enterré (12) sur le substrat et une couche épitaxiale (14) de recouvrement, tous les deux étant d'un second type de conductivité, une couche isolante (42) sur la couche épitaxiale avec une ouverture de zone de base (43) ;
- une zone de base (70) du premier type de conductivité formée à l'intérieur de la couche épitaxiale (14) ;
- une barrette isolante (50) latérale formée sur la paroi latérale de la couche isolante (42) autour de l'ouverture de la zone de base (43), des première et seconde parties de la barrette isolante latérale se trouvant sur des côté opposés de l'ouverture de base (43) l'une par rapport à l'autre ;
- une couche de contact d'émetteur en polysilicium dopé (52) qui est disposée sur la partie de la surface de la zone de base (70) qui se trouve à l'intérieur de l'ouverture de la zone de base (43), qui s'étend jusqu'à la première partie de la barrette isolante latérale (50) et une partie de la couche isolante (42) et qui les recouvre ;
- une couche de contact de base en polysilicium dopé (62) sur une partie de la surface de la zone de base (70) ;
- une zone d'émetteur (74) du second type de conductivité emboîtée à l'intérieur de la région de base (70) en dessous de la couche de contact d'émetteur (52) en polysilicium à l'endroit où elle est en contact avec la zone de base (70), une zone extrinsèque de base (72) du premier type de conductivité disposée en dessous de la couche de contact de base (62) en polysilicium à l'endroit où elle est en contact avec la surface de la zone de base (70) et une zone de contact de collecteur (68) s'étendant à travers ladite couche épitaxiale (14) vers ledit collecteur enterré (12),
caractérisé en ce que :
- lesdites zones de base intrinsèque et extrinsèque sont formées à l'intérieur de ladite ouverture de la zone de base (43) ;
- une barrette (58) isolante de couche et d'espacement recouvre le bord de la couche (52) de contact en polysilicium d'émetteur sur la zone de base et la partie de recouvrement de la zone de base à l'intérieur de l'ouverture de base (43) ; et
- ladite couche (62) de contact de base en polysilicium est prévue jusqu'à la barrette (58) isolante de couche et d'espacement et la recouvre en partie.

6. Transistor bipolaire selon la revendication 5, comprenant une couche en siliciure (84,86,88) formée sur lesdites couches de contact de base et d'émetteur en polysilicium (52,62) et ladite zone de contact de collecteur (68).

7. Transistor selon la revendication 5 ou 6, dans lequel ladite zone de contact de collecteur (68) est alignée avec un bord de ladite couche de contact d'émetteur en polysilicium (52) à distance de ladite zone de base intrinsèque (70).

8. Transistor selon l'une quelconque des revendications 5,6 et 7, dans lequel ledit premier type de conductivité est le type P et ledit second type de conductivité est le type N.
